# EUROPÄISCHE PATENTSCHRIFT

(11) **EP 2 686 463 B1**
(45) Veröffentlichungstag und Bekanntmachung des Hinweises auf die Patenterteilung: **12.04.2017**
(21) Anmeldenummer: 12715314.6
(22) Anmeldetag: 15.03.2012
(51) Int. Cl.: C23C 16/34, C23C 16/30

(54) **BESCHICHTETER KÖRPER UND VERFAHREN ZU DESSEN HERSTELLUNG**
COATED BODY AND METHOD FOR PRODUCTION OF SAME
CORPS POURVU D'UN REVÊTEMENT ET SON PROCÉDÉ DE PRODUCTION

(30) Priorität: 18.03.2011 AT 3832011
(43) Veröffentlichungstag der Anmeldung: 22.01.2014
(73) Patentinhaber: Boehlerit GmbH & Co. KG., 8605 Kapfenberg (AT)
(72) Erfinder: PITONAK, Reinhard, A-8600 Bruck an der Mur (AT); WEIßENBACHER, Ronald, A-8600 Bruck an der Mur (AT); GASS, Martina, A-8641 St. Marein (AT)
(74) Vertreter: Wirnsberger, Gernot
(86) Internationale Anmeldenummer: PCT/AT2012/050036
(87) Internationale Veröffentlichungsnummer: WO 2012/126031

(56) Entgegenhaltungen:
- DE-A1- 2 610 456
- DE-A1-102008 013 965
- JP-A- 59 041 466
- US-B1- 6 254 984
- K Tönshoff ET AL: "Performance of oxygen-rich TiALON coatings in dry cutting applications", Surface and Coatings Technology, vol. 108-109, 1 October 1998 (1998-10-01), pages 535-542, XP55138748, ISSN: 0257-8972, DOI: 10.1016/S0257-8972(98)00637-9

## Beschreibung

Die Erfindung betrifft einen Körper, der zumindest bereichsweise eine Beschichtung mit einer ersten Beschichtungslage aufweist, die mit Aluminium, Titan und Stickstoff gebildet ist.

Des Weiteren betrifft die Erfindung eine Verwendung eines derartigen Körpers.

Schließlich betrifft die Erfindung ein Verfahren zur Herstellung eines Körpers, wobei zumindest bereichsweise eine Beschichtung mit einer ersten Beschichtungslage abgeschieden wird, die mit Aluminium, Titan und Stickstoff gebildet wird.

Werkzeuge, die im Einsatz hohen mechanischen Belastungen und/oder hohen Temperaturen ausgesetzt sind, werden oftmals beschichtet, um entsprechenden Anforderungen im Einsatz möglichst lange standhalten zu können. Beispielsweise werden Schneidwerkzeuge oder Teile davon, insbesondere Schneidplatten für Dreh- oder Fräsoperationen, in der Regel beschichtet, wenn eine hohe Standzeit eines Werkzeuges gewünscht ist.

Für die Herstellung von verschleißfesten Beschichtungen sind auch Schichten im Materialsystem Titan-Aluminium-Stickstoff (TiAIN) bekannt geworden. In jüngerer Zeit wurde hierbei versucht, den Aluminiumgehalt höher zu halten als jenen des Titans, weshalb häufig auch vom Materialsystem Aluminium-Titan-Stickstoff (AlTiN) gesprochen wird. Gemäß der WO 03/085152 A2 ist es möglich, monophasige AITiN-Beschichtungslagen mit kubischer bzw. NaCl-Struktur und mit AIN-Gehalten bis zu 67 % herzustellen. Bei höheren AIN-Gehalten entsteht allerdings zuerst ein Gemisch aus kubischem und hexagonalem AlTiN und bei AIN-Gehalten von größer als 75 % nur noch eine nicht verschleißfeste hexagonale Phase.

In Bezug auf AITiN-Schichten wurde insbesondere auch versucht, mittels Chemical Vapor Deposition (CVD) möglichst einphasige kubische Schichten mit der allgemeinen Zusammensetzung AlₓTi₁₋ₓN mit x ≥ 0,75 herzustellen, was gemäß der DE 10 2005 032 860 B4 mittels thermischer CVD bei Temperaturen im Bereich zwischen 700 °C und 900 °C möglich ist (siehe auch I. Endler et al., Proceedings Euro PM 2006, Ghent, Belgien, 23. bis 25. Oktober 2006, Vol. 1, 219).

AlTiN-Schichten mit einem hohen Anteil von Aluminium und bevorzugt verschleißfester kubischer Struktur können auch zusätzlich mit einer Schicht aus Aluminiumoxid (Al₂O₃) versehen sein, wie dies aus der WO 2009/112115 A1 bekannt ist. Eine Al₂O₃-Schicht als äußerste Beschichtungslage kann eine Oxidationsbeständigkeit bei hohen Temperaturen erhöhen. Ein Problem bei der in der WO 2009/112115 A1 dargestellten Schichtfolge ist allerdings, dass AlₓTi₁₋ₓN mit kubischer Struktur metastabil ist und bei Temperaturen von 1000 °C in die thermodynamisch stabilere hexagonale Phase bzw. mehrere hexagonale Phasen zerfällt. Da mittels eines CVD-Verfahrens eine stabile Al₂O₃-Schicht erst bei Temperaturen von 1000 °C bis 1050 °C mit einer praktikablen Abscheidungsrate erhalten werden kann, ist eine wirtschaftliche Herstellung eines solchen Schichtaufbaus mittels CVD nicht möglich.

DE 10 2008 013965 A1 offenbart einen hartstoffbeschichteten Körper mit einer ersten Beschichtungslage, die aus Aluminium, Titan und Stickstoff gebildet ist, und einer zweiten Beschichtungslage, die aus Aluminiumoxid besteht.

Aufgabe der Erfindung ist es, einen Körper der eingangs genannten Art anzugeben, der einerseits wirtschaftlich praktikabel herstellbar ist und andererseits für höchste Anforderungen im Einsatz, insbesondere bei gleichzeitiger mechanischer und thermischer Beanspruchung, ausgelegt ist.

Ein weiteres Ziel ist es, eine Verwendung eines derartigen Körpers anzugeben.

Eine verfahrensmäßige Aufgabe der Erfindung besteht darin, ein Verfahren der eingangs genannten Art anzugeben, das auf wirtschaftlich praktikable Weise die Herstellung eines Körpers erlaubt, der im Einsatz höchsten Belastungen, insbesondere mechanischen und/oder thermischen Beanspruchungen, lange standhält.

Die Aufgabe der Erfindung wird dadurch gelöst, dass bei einem Körper der eingangs genannten Art die Beschichtung, welche mit einem CVD-Verfahren abgeschieden wird, zumindest eine zweite Beschichtungslage aufweist, die aus Aluminium, Sauerstoff und Stickstoff sowie optional Kohlenstoff gebildet ist, wobei Aluminium teilweise durch ein anderes Metall ersetzt sein kann.

Ein erfindungsgemäßer Körper weist insbesondere den Vorteil auf, dass dieser wirtschaftlich praktikabel mittels CVD erstellt werden kann, ohne dass die erste Beschichtungslage, in der Regel eine AlTiN-Beschichtungslage Schaden erleidet. Somit ist die gewünschte hohe Verschleißfestigkeit, welche durch die bzw. mit der AITiN-Beschichtungslage erzielt wird, vollständig gegeben und gleichzeitig eine Oxidationsbeständigkeit, insbesondere bei hohen Temperaturen, wie diese beispielsweise bei einem Drehen von metallischen Werkstücken oder anderen spanabhebenden Verfahren auftreten können, außerordentlich hoch. Die Oxidationsbeständigkeit wird hauptsächlich durch die zweite Beschichtungslage erreicht, die aus Aluminium, Sauerstoff und Stickstoff sowie optional Kohlenstoff gebildet ist. Diese Beschichtungslage bzw. Schicht lässt sich unter den gleichen thermischen Bedingungen abscheiden wie die erste Beschichtungslage bzw. eine AlTiN-Beschichtungslage. Aluminium kann dabei teilweise durch ein anderes Metall ersetzt werden, beispielsweise Silicium. Ersetzen bedeutet in diesem Zusammenhang, dass Aluminium in der zweiten Beschichtungslage das überwiegende Metall, also mit einem Anteil von mehr als 50 % bezogen auf alle Metalle, bleibt. Bevorzugt werden allerdings, wenn überhaupt, nur geringe Gehalte eines weiteren Metalls zugesetzt, in der Regel weniger als 5 % bezogen auf den Gesamtgehalt an Metallen in der zweiten Beschichtungslage.

Da die zweite Beschichtungslage aus Aluminium, Sauerstoff und Stickstoff sowie optional Kohlenstoff eine Antihaftwirkung aufweist, ergeben sich zusätzliche Vorteile, wenn diese Beschichtungslage eine äußerste Beschichtungslage ist.

Der Grundkörper eines erfindungsgemäßen Körpers ist üblicherweise ein Schnellarbeitsstahl, ein Cermet oder ein Hartmetall, wobei Hartmetalle für höchste Belastungen bei spanabhebenden Prozessen bevorzugt sind.

Zweckmäßig ist es, insbesondere wenn der Grundkörper aus einem Hartmetall gebildet ist, wenn unmittelbar am Grundkörper eine Anbindungsschicht aus Titannitrid abgeschieden ist, wobei die Anbindungsschicht vorzugsweise eine Dicke von weniger als 1,0 µm aufweist. Eine Anbindungsschicht aus Titannitrid am Grundkörper erlaubt einen weiteren Schichtaufbau durch Abscheiden zusätzlicher Beschichtungslagen, wobei diese zusätzlichen Beschichtungslagen durch die Anbindungsschicht zug- und/oder druckentlastet sind. Titannitrid hat sich insbesondere in Bezug auf Hartmetalle mit Bindemetall aus Cobalt als günstig erwiesen, da während des Abscheidens der Anbindungsschicht Cobalt aus dem Grundkörper in das Titannitrid diffundiert und dadurch für eine feste Anbindung dieser und damit auch weiterer Schichten sorgt. Für die Zwecke der Anbindung ist es ausreichend, dass die Anbindungsschicht eine Dicke von weniger als 1,0 µm aufweist. Üblicherweise beträgt eine Dicke der Anbindungsschicht etwa 0,5 µm oder weniger.

Die erste Beschichtungslage kann unmittelbar auf einer Anbindungsschicht abgeschieden sein, von Vorteil ist es jedoch, wenn die erste Beschichtungslage auf einer weiteren Beschichtungslage abgeschieden ist, die aus einem Titancarbonitrid gebildet ist. Dabei ist es von besonderem Vorteil, wenn die weitere Beschichtungslage im Querschnitt eine kolumnare Struktur aufweist, die im Wesentlichen senkrecht zu einer Oberfläche der Beschichtungslage verläuft. Derartige Beschichtungslagen sind aus dem Stand der Technik in anderem Zusammenhang bekannt und haben sich im Rahmen der Erfindung als besonders geeignete Zwischenschichten erwiesen. Insbesondere hat sich gezeigt, dass die erste Beschichtungslage bei Abscheiden auf einer derartigen weiteren Beschichtungslage aus Titancarbonitrid mit einer vorteilhaften Struktur ausgebildet sein kann. Für diese Zwecke ist es ausreichend, wenn die weitere Beschichtungslage eine Dicke von bis zu 10 µm, vorzugsweise 1 bis 8 µm, insbesondere 2 bis 5 µm aufweist. Die weitere Beschichtungslage kann dabei auf einer Anbindungsschicht aus Titancarbonitrid abgeschieden sein.

Die erste Beschichtungslage weist vorteilhafterweise eine durchschnittliche Zusammensetzung AlₓTi₁₋ₓN auf, wobei x ≥ 0,65, vorzugsweise ≥ 0,80, insbesondere ≥ 0,90, ist. Dabei kann sich die angegebene Zusammensetzung auf eine einzige Phase beziehen, aber auch auf eine erste Beschichtungslage, welche neben Anteilen von AlTiN auch AIN und/oder TiN, in geringeren Anteilen, aufweist. Zweckmäßig ist es im jeden Fall, dass die erste Beschichtungslage einen Anteil von zumindest 50 %, vorzugsweise zumindest 60 %, insbesondere zumindest 70 %, einer kubischen Phase, insbesondere einer kubischen AlₓTi₁₋ₓN-Phase aufweist.

Die erste Beschichtungslage kann im Übrigen auch einen Anteil einer hexagonalen Phase, insbesondere einer hexagonalen AlₓTi₁₋ₓN-Phase, aufweisen, wenngleich die entsprechenden Anteile kubischer Phase möglichst groß sein sollten, um eine hohe Verschleißfestigkeit zu erhalten.

Als besonders günstig hat es sich erwiesen, wenn die erste Beschichtungslage im Querschnitt in einem dem Körper zugewandten Bereich zumindest bereichsweise eine lamellenartige Struktur aufweist. Diese lamellenartige Struktur kann vom Grundkörper ausgehend betrachtet nach außen hin in eine andere Morphologie übergehen.

Die erste Beschichtungslage, die wie erwähnt vornehmlich für eine Verschleißfestigkeit vorgesehen ist, weist eine Dicke von bis zu 10 µm auf, wobei sich Dicken von 3 bis 8 µm als besonders zweckmäßig für viele Anwendungen im Bereich spanabhebender Bearbeitung von Werkstücken erwiesen hat.

Die zweite Beschichtungslage ist nicht nur oxidationsstabil, sondern auch besonders reibarm. Um diesen Effekt zu nützen, ist es besonders zweckmäßig, dass die zweite Beschichtungslage eine äußerste Beschichtungslage ist.

Möglich ist es auch, dass mehrere erste Beschichtungslagen abwechselnd mit zweiten Beschichtungslagen angeordnet sind. Durch dieses Wechselspiel von besonders verschleißfesten und besonders oxidationsstabilen bzw. als Hitzeschild dienenden Beschichtungslagen kann eine relativ dicke, im Wesentlichen homogene Kombinationsschicht aufgebaut werden, in welcher die entsprechenden Vorteile kombiniert sind. Dabei ist es zweckmäßig, dass die abwechselnd angeordneten ersten Beschichtungslagen und zweiten Beschichtungslagen jeweils eine Dicke von weniger als 2 µm, vorzugsweise weniger als 1,2 µm, insbesondere weniger als 1,0 µm aufweisen. Die abwechselnd angeordneten Beschichtungslagen sind zweckorientiert außenseitig angeordnet, wobei eine zweite Beschichtungslage eine äußerste Beschichtungslage ist.

Im Sinne einer praktikablen Herstellung ist es bevorzugt, dass alle Beschichtungslagen durch CVD abgeschieden sind. Dies gilt auch für eine optional vorgesehene Anbindungsschicht.

Entsprechend den vorstehend dargestellten Vorteilen ist ein erfindungsgemäßer Körper bevorzugt als Schneidwerkzeug oder Schneideinsatz, beispielsweise eine Schneidplatte, ausgebildet. Daher ist eine bevorzugte Verwendung eines erfindungsgemäßen Körpers eine spanabhebende Bearbeitung von Werkstücken, insbesondere metallischen Werkstücken. Dabei kommen insbesondere bei einem Drehen, das in der Regel mit hohen Temperaturen am Schneidwerkzeug bzw. Schneideinsatz verbunden ist, die Vorteile einer hohen Verschleißfestigkeit und gleichzeitig Oxidationsbeständigkeit sowie Reibarmheit bzw. Antihaftwirkung besonders deutlich zum Tragen.

Die weitere Aufgabe der Erfindung wird dadurch gelöst, dass bei einem Verfahren der eingangs genannten Art zumindest eine zweite Beschichtungslage abgeschieden wird, die mit Aluminium, Sauerstoff und Stickstoff sowie optional Kohlenstoff gebildet wird, wobei Aluminium optional teilweise durch ein anderes Metall ersetzt wird.

Ein mit einem erfindungsgemäßen Verfahren erzielter Vorteil ist darin zu sehen, dass auf wirtschaftlich praktikable Weise ein Körper bereitgestellt werden kann, der eine verschleißfeste, gleichzeitig aber auch oxidationsstabile und thermisch hoch beanspruchbare Beschichtung aufweist. Dabei kann insbesondere auch ein Körper hergestellt werden, wie dieser zuvor erläutert wurde. Für bestimmte Anwendungsgebiete, beispielsweise eine spanabhebende Bearbeitung wie ein Drehen von metallischen Werkstücken, wird die Beschichtung auf einem Grundkörper, der aus einem Hartmetall gebildet ist, abgeschieden.

Das Hartmetall kann beispielsweise Carbide, Nitride und/oder Carbonitride eines oder mehrerer der Metalle der 4. bis 6. Hauptgruppe des Periodensystems der Elemente mit einem Anteil von 85 bis 95 Gewichtsprozent (Gew.-%) sowie als Rest ein oder mehrere Bindemetalle, ausgewählt aus der Gruppe bestehend aus Cobalt, Nickel und Eisen, aufweisen. Insbesondere bei Verwendung eines Hartmetalls ist es dann zweckmäßig, dass am Grundkörper eine Anbindungsschicht aus Titannitrid abgeschieden wird, wobei die Anbindungsschicht vorzugsweise eine Dicke von weniger als 1,0 µm aufweist. Die Anbindungsschicht ist zweckmäßig, um eine gute Anbindung der Beschichtung insgesamt an den Grundkörper bzw. das Hartmetall zu erreichen.

Bevorzugt ist es, dass eine weitere Beschichtungslage aus einem Titancarbonitrid abgeschieden wird, auf welcher die erste Beschichtungslage abgeschieden wird. Zweckmäßig ist es dabei, dass die weitere Beschichtungslage bei einer Temperatur von 700 °C bis 900 °C aus einer Gasphase abgeschieden wird, die neben Titantetrachlorid und einem Trägergas auch Acetonitril enthält. Das Acetonitril dient als Stickstoff- und Kohlenstoffquelle. Eine Abscheidung im genannten Temperaturbereich mittels CVD führt zu einer sogenannten Mitteltemperatur-Titancarbonitridschicht (MT-TiCN), die einen kolumnaren Aufbau aufweist bzw. im Querschnitt eine stängelige Struktur zeigt, die normal zur Oberfläche des Grundkörpers verläuft. Auf einer derartigen MT-TiCN-Beschichtungslage, die vorzugsweise mit einer Dicke von bis zu 10 µm, vorzugsweise 1 bis 8 µm, insbesondere 2 bis 5 µm, abgeschieden wird, lässt sich unmittelbar eine AlₓTi₁₋ₓN-Beschichtungslage mit besonderer bzw. vorteilhafter Morphologie abscheiden. Dabei kann die weitere Beschichtungslage aus MT-TiCN auf einer Anbindungsschicht aus Titannitrid abgeschieden werden. Die erste Beschichtungslage wird bevorzugt aus einer Gasphase mit AlCl₃, HCl, H₂, TiCl₄ und einem Gemisch von NH₃ und N₂ abgeschieden, wobei das Gemisch von NH₃ und N₂ über eine gesonderte Leitung zugeführt wird. Dabei beträgt ein Druck vorteilhafterweise 15 bis 80 mbar, bevorzugt 20 bis 40 mbar. Die Abscheidung der ersten Beschichtungslage unter diesen Bedingungen wird bei einer Temperatur von 780 °C bis 840 °C durchgeführt. Zweckmäßigerweise wird die erste Beschichtungslage mit einer Dicke von bis zu 10 µm, vorzugsweise 3 bis 8 µm, abgeschieden. Die zweite Beschichtungslage kann bei gleichen Bedingungen abgeschieden werden, wobei die Gasphase jedoch kein TiCl₄, zusätzlich aber CO und CO₂ enthält.

Das erfindungsgemäße Verfahren kann so geführt werden, dass mehrere erste Beschichtungslagen abwechselnd mit zweiten Beschichtungslagen abgeschieden werden. In diesem Fall ist es zweckmäßig, dass die abwechselnd abgeschiedenen ersten Beschichtungslagen und zweiten Beschichtungslagen jeweils mit einer Dicke von weniger als 2 µm, vorzugsweise weniger als 1,2 µm, insbesondere weniger als 1,0 µm, abgeschieden werden. Durch eine derartige wechselweise Abscheidung einzelner Beschichtungslagen wird ein kombinierter Schichtaufbau mit hoher Verschleißfestigkeit und gleichzeitig hoher Oxidationsbeständigkeit erreicht. Zweckmäßig ist es, wechselweise zumindest zwei erste und zwei zweite Beschichtungslagen vorzusehen. Nach oben hin ist einer Anzahl der wechselweisen Anordnung der einzelnen ersten Beschichtungslagen und zweiten Beschichtungslagen keine Grenze gesetzt, wenngleich es aus praktischen Gesichtspunkten ausreichend ist, wenn die abwechselnd angeordneten Schichten eine maximale Dicke von 15 µm, vorzugsweise 12 µm, aufweisen. Dabei kann insbesondere auch vorgesehen sein, dass die abwechselnd abgeschiedenen Beschichtungslagen außenseitig abgeschieden werden, wobei eine zweite Beschichtungslage als eine äußerste Beschichtungslage abgeschieden wird. Dadurch kann die kombinierte Funktionsschicht im Einsatz eine volle Wirkung entfalten. Dies ist auch dann zutreffend, wenn zusätzlich als äußerste Lage eine dünne Schicht aus Titannitrid, vorzugsweise mit einer Dicke von weniger als 1,0 µm, als Verschleißindikator abgeschieden ist.

Bevorzugt ist vorgesehen, dass alle Beschichtungslagen mittels CVD abgeschieden werden. Dabei kann insbesondere im Sinne einer effizienten Verfahrensführung vorgesehen sein, dass eine Anbindungsschicht abgeschieden wird, vorzugsweise aus Titannitrid, wonach eine weitere Beschichtungslage abgeschieden wird, wonach die erste Beschichtungslage abgeschieden wird, wobei eine Abscheidungstemperatur in jedem Abscheidungsschritt gesenkt wird. Ein Grundkörper kann bei einer derartigen Verfahrensführung auf eine Temperatur von beispielsweise 900 °C gebracht werden, um die Anbindungsschicht abzuscheiden. Anschließend wird der Grundkörper zur Abscheidung der weiteren Beschichtungslage abkühlen gelassen. Nach Aufbringen der weiteren Beschichtungslage wird der Grundkörper nochmals abkühlen gelassen, wobei und/oder wonach die erste Beschichtungslage abgeschieden wird. Die zweite Beschichtungslage kann dann bei derselben Temperatur wie die erste Beschichtungslage abgeschieden werden.

Weitere Merkmale, Vorteile und Wirkungen der Erfindung ergeben sich anhand des nachfolgend dargestellten Ausführungsbeispiels derselben. In der Zeichnung, auf welche dabei Bezug genommen wird, zeigen:
Fig. 1 eine schematische Darstellung eines Schichtaufbaus mit mehreren Beschichtungslagen;
Fig. 2 eine rasterelektronenmikroskopische Aufnahme eines Hartmetallkörpers mit einer Beschichtung.

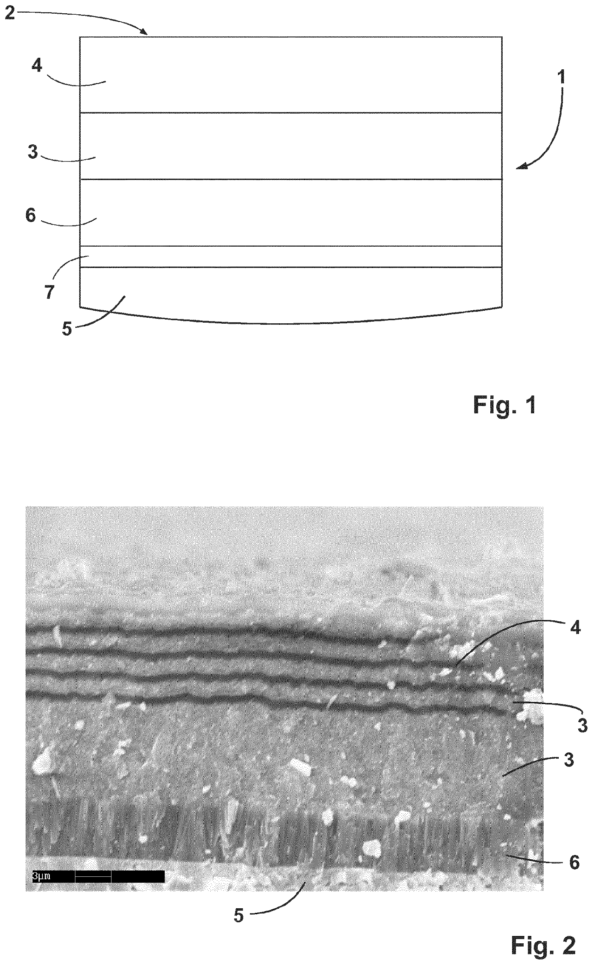

In Fig. 1 ist ein erfindungsgemäßer Körper 1 schematisch dargestellt. Der Körper 1 weist einen Grundkörper 2 auf, der in der Regel ein Hartmetall ist. Auf diesem Hartmetall bzw. dem Grundkörper 2 ist eine Anbindungsschicht 7 aus Titannitrid (TiN) abgeschieden. Die Anbindungsschicht 7 ist in der Regel weniger als 1,0 µm dick. Auf der Anbindungsschicht 7 ist eine weitere Beschichtungslage 6 abgeschieden, die optional ist, allerdings Vorteile bringt. Die weitere Beschichtungslage 6 kann insbesondere aus MT-TiCN bestehen, das eine stängelige bzw. kolumnare Struktur aufweist, die überwiegend normal zu einer

Oberfläche des Grundkörpers 2 verläuft. Auf der weiteren Beschichtungslage 6 ist im Anschluss eine erste Beschichtungslage 3 abgeschieden, die aus AlTiN besteht, welches überwiegend kubische Struktur aufweist, wenngleich auch hexagonale Anteile vorhanden sein können. Möglich ist es auch, dass Anteile von AIN und/oder TiN vorliegen, allerdings nur in geringeren Anteilen bis maximal 30 %. Auf der ersten Beschichtungslage 3 ist eine zweite Beschichtungslage 4 abgeschieden, die mit Aluminium, Stickstoff und Sauerstoff gebildet ist und gegebenenfalls geringe Anteile an Kohlenstoff enthalten kann. Diese zweite Beschichtungslage 4 mit der allgemeinen Zusammensetzung AION bzw. AIO(C)N ist äußerst reibarm, oxidationsbeständig und temperaturstabil. Die zweite Beschichtungslage 4 ist daher zweckmäßigerweise außenseitig angeordnet.

In Fig. 2 ist eine rasterelektronenmikroskopische Aufnahme eines erfindungsgemäßen Körpers 1 gezeigt, wobei der Schichtaufbau einschließlich der nicht ersichtlichen Anbindungsschicht 7 prinzipiell jenem gemäß Fig. 1 entspricht, wobei allerdings mehrere erste Beschichtungslagen 3 und zweite Beschichtungslagen 4 wechselweise angeordnet sind und wobei der Körper 1 außenseitig mit einer zweiten Beschichtungslage 4 abschließt. Die ersten Beschichtungslagen 3 und die zweiten Beschichtungslagen 4 können bei wechselweiser Anordnung in der Schichtdicke variiert werden, um je nach Anwendung ein gewünschtes Eigenschaftsprofil einzustellen.

Eine Beschichtung auf einem Körper 1 kann mittels CVD hergestellt werden. Prozessparameter sind in der nachstehenden Tabelle 1 angegeben. In Tabelle 2 sind Eigenschaften der einzelnen Beschichtungslagen 3, 4, 6, 7 dargestellt.

**Tabelle 1 - Prozessparameter**

| | Temperatur (°C) | Gaszusammensetzung/Gasfluss (l/min) bzw. TiCl₄ und CH₃CN (ml/min) |
|---|---|---|
| Beschichtungslage | | |
| TiN | 880 - 900 | TiCl₄/2,7, N₂/14, H₂/17 |
| MT-TiCN | 750 - 850 | CH₃CN/0,5, TiCl₄/2,7, N₂/19, H₂/3 |
| AlTiN | 750 - 850* | HCl-AlCl₃/2,7-0,9, TiCl₄/0,3, NH₃-N₂/0,9-4,5, H₂/64 |
| AION | 750 - 850* | HCl-AlCl₃/2,7-0,9, CO₂/0,75, CO/0,5, NH₃-N₂/0,75-4,5, H₂/64 |

| | | |
|---|---|---|
| * gleiche Temperatur bei mehrfach wechselweiser Abscheidung AlTiN/AlON | | |

**Tabelle 2 - Eigenschaften der Beschichtungslagen**

| Beschichtungslage | Schichtdicke (µm) | | Zusammensetzung |
|---|---|---|---|
| | allgemein | bevorzugt | |
| TiN | ≤ 2 | 0,25-0,75 | TiN |
| MT-TiCN | 1-10 | 2-5 | TiCₐN₁₋ₐ, a = 0, 4 - 0,6 |
| AlTiN | 1-10 | 3 - 8* | AlₓTi₁₋ₓN, x = 0,85 - 0,98 |
| AION | 1-10 | 3 - 8* | AION |

| | | | |
|---|---|---|---|
| * geringer bei mehrfach wechselweiser Anordnung AlTiN/AlON | | | |

Die zweite Beschichtungslage 4 kann frei von Kohlenstoff ausgebildet sein, allerdings kann bei der gewählten Gaszusammensetzung gemäß Tabelle 1 nicht ausgeschlossen werden, dass auch Anteile an Kohlenstoff in der zweiten Beschichtungslage 4 vorliegen.

Erfindungsgemäße Körper 1 zeichnen sich durch hohe Verschleißbeständigkeit, auch bei hohen Temperaturen, aus. Dementsprechend besteht eine bevorzugte Anwendung erfindungsgemäßer Körper 1 in der Verwendung als Schneidplatten, insbesondere Schneidplatten, die bei einem Drehen eingesetzt werden. Selbstverständlich ist es aber auch möglich, entsprechende Schneidplatten bei weniger anspruchsvollen spanabhebenden Verfahren, insbesondere einem Fräsen, einzusetzen.

## Patentansprüche

1. Körper (1), der zumindest bereichsweise eine mit einem CVD-Verfahren abgeschiedene Beschichtung (2) mit einer ersten Beschichtungslage (3) aufweist, die mit Aluminium, Titan und Stickstoff gebildet ist, **dadurch gekennzeichnet, dass** die Beschichtung (2) zumindest eine zweite Beschichtungslage (4) aufweist, die aus Aluminium, Sauerstoff und Stickstoff sowie optional Kohlenstoff gebildet ist, wobei Aluminium teilweise durch ein anderes Metall ersetzt sein kann.

2. Körper (1) nach Anspruch 1, **dadurch gekennzeichnet, dass** der Körper (1) einen Grundkörper (5) aufweist, der aus einem Hartmetall gebildet ist.

3. Körper (1) nach Anspruch 1 oder 2, **dadurch gekennzeichnet, dass** unmittelbar am Grundkörper (5) eine Anbindungsschicht (7) aus Titannitrid abgeschieden ist, wobei die Anbindungsschicht (7) vorzugsweise eine Dicke von weniger als 1,0 µm aufweist.

4. Körper (1) nach einem der Ansprüche 1 bis 3, **dadurch gekennzeichnet, dass** die erste Beschichtungslage (3) auf einer weiteren Beschichtungslage (6) abgeschieden ist, die aus einem Titancarbonitrid gebildet ist.

5. Körper (1) nach Anspruch 4, **dadurch gekennzeichnet, dass** die weitere Beschichtungslage (6) im Querschnitt eine kolumnare Struktur aufweist, die im Wesentlichen senkrecht zu einer Oberfläche der Beschichtungslage (6) verläuft.

6. Körper (1) nach Anspruch 4 oder 5, **dadurch gekennzeichnet, dass** die weitere Beschichtungslage (6) eine Dicke von bis zu 10 µm, vorzugsweise 1 bis 8 µm, insbesondere 2 bis 5 µm, aufweist.

7. Körper (1) nach einem der Ansprüche 4 bis 6, **dadurch gekennzeichnet, dass** die weitere Beschichtungslage (6) auf einer Anbindungsschicht aus Titannitrid abgeschieden ist.

8. Körper (1) nach einem der Ansprüche 1 bis 7, **dadurch gekennzeichnet, dass** die erste Beschichtungslage (3) eine Zusammensetzung AlₓTi₁₋ₓN aufweist, wobei x ≥ 0,65, vorzugsweise ≥ 0,80, insbesondere ≥ 0,90, ist.

9. Körper (1) nach einem der Ansprüche 1 bis 8, **dadurch gekennzeichnet, dass** die erste Beschichtungslage (3) einen Anteil von zumindest 50 %, vorzugsweise zumindest 60 %, insbesondere zumindest 75 %, einer kubischen Phase, insbesondere einer kubischen AlₓTi₁₋ₓN-Phase, aufweist.

10. Körper (1) nach einem der Ansprüche 1 bis 9, **dadurch gekennzeichnet, dass** die erste Beschichtungslage (3) einen Anteil einer hexagonalen Phase, insbesondere einer hexagonalen AlₓTi₁₋ₓN-Phase, aufweist.

11. Körper (1) nach einem der Ansprüche 1 bis 10, **dadurch gekennzeichnet, dass** die erste Beschichtungslage (3) im Querschnitt in einem dem Körper zugewandten Bereich zumindest bereichsweise eine lamellenartige Struktur aufweist.

12. Körper (1) nach einem der Ansprüche 1 bis 11, **dadurch gekennzeichnet, dass** die erste Beschichtungslage (3) eine Dicke von bis zu 10 µm, vorzugsweise 3 bis 8 µm, aufweist.

13. Körper (1) nach einem der Ansprüche 1 bis 12, **dadurch gekennzeichnet, dass** mehrere erste Beschichtungslagen (3) abwechselnd mit zweiten Beschichtungslagen (4) angeordnet sind.

14. Körper (1) nach Anspruch 13, **dadurch gekennzeichnet, dass** die abwechselnd angeordneten ersten Beschichtungslagen (3) und zweiten Beschichtungslagen (4) jeweils eine Dicke von weniger als 2 µm, vorzugsweise weniger als 1,2 µm, insbesondere weniger als 1,0 µm, aufweisen.

15. Körper (1) nach Anspruch 13 oder 14, **dadurch gekennzeichnet, dass** die abwechselnd angeordneten Beschichtungslagen (3, 4) außenseitig angeordnet sind, wobei eine zweite Beschichtungslage (4) eine äußerste Beschichtungslage ist.

16. Körper (1) nach einem der Ansprüche 1 bis 15, **dadurch gekennzeichnet, dass** der Körper (1) als Schneidwerkzeug oder Schneideinsatz ausgebildet ist.

17. Verfahren zur Herstellung eines Körpers (1), insbesondere eines Körpers (1) nach einem der Ansprüche 1 bis 16, wobei zumindest bereichsweise mit einem CVD-Verfahren eine Beschichtung (2) mit einer ersten Beschichtungslage (3) abgeschieden wird, die mit Aluminium, Titan und Stickstoff gebildet wird, **dadurch gekennzeichnet, dass** zumindest eine zweite Beschichtungslage (4) abgeschieden wird, die mit Aluminium, Sauerstoff und Stickstoff sowie optional Kohlenstoff gebildet wird, wobei Aluminium optional teilweise durch ein anderes Metall ersetzt wird.

18. Verfahren nach Anspruch 17, **dadurch gekennzeichnet, dass** die Beschichtung (2) auf einem Grundkörper (5), der aus einem Hartmetall gebildet ist, abgeschieden wird.

19. Verfahren nach Anspruch 18, **dadurch gekennzeichnet, dass** unmittelbar am Grundkörper (5) eine Anbindungsschicht aus Titannitrid abgeschieden wird, wobei die Anbindungsschicht vorzugsweise eine Dicke von weniger als 1,0 µm aufweist.

20. Verfahren nach einem der Ansprüche 17 bis 19, **dadurch gekennzeichnet, dass** eine weitere Beschichtungslage (6) aus einem Titancarbonitrid abgeschieden wird, auf welcher die erste Beschichtungslage (3) abgeschieden wird.

21. Verfahren nach Anspruch 20, **dadurch gekennzeichnet, dass** die weitere Beschichtungslage (6) bei einer Temperatur von 700 °C bis 900 °C aus einer Gasphase abgeschieden wird, die neben Titantetrachlorid und einem Trägergas Acetonitril enthält.

22. Verfahren nach einem der Ansprüche 17 bis 21, **dadurch gekennzeichnet, dass** die erste Beschichtungslage (3) aus einer Gasphase mit AlCl₃, HCl, H₂, TiCl₄ und einem Gemisch von NH₃ und N₂ abgeschieden wird.

23. Verfahren nach Anspruch 22, **dadurch gekennzeichnet, dass** die erste Beschichtungslage (3) bei einem Druck von 15 bis 80 mbar, bevorzugt 20 bis 40 mbar, abgeschieden wird.

24. Verfahren nach Anspruch 22 oder 23, **dadurch gekennzeichnet, dass** die erste Beschichtungslage (3) bei einer Temperatur von 780 °C bis 840 °C abgeschieden wird.

25. Verfahren nach einem der Ansprüche 17 bis 24, **dadurch gekennzeichnet, dass** die zweite Beschichtungslage (4) aus einer Gasphase mit AlCl₃, HCl, H₂, CO₂, CO und einem Gemisch von NH₃ und N₂ abgeschieden wird.

26. Verfahren nach einem der Ansprüche 17 bis 24, **dadurch gekennzeichnet, dass** mehrere erste Beschichtungslagen (3) abwechselnd mit zweiten Beschichtungslagen (4) abgeschieden werden.

27. Verfahren nach Anspruch 26, **dadurch gekennzeichnet, dass** die abwechselnd abgeschiedenen Beschichtungslagen (3, 4) außenseitig abgeschieden werden, wobei eine zweite Beschichtungslage (4) als eine äußerste Beschichtungslage abgeschieden wird.

28. Verfahren nach einem der Ansprüche 17 bis 27, **dadurch gekennzeichnet, dass** alle Beschichtungslagen durch CVD abgeschieden werden.

## Claims

1. A body (1), which comprises at least in sections a coating (2) deposited using a CVD process, comprising a first coating layer (3) which is formed with aluminium, titanium and nitrogen, **characterised in that** the coating (2) comprises at least a second coating layer (4) which is formed from aluminium, oxygen and nitrogen and optionally carbon, wherein aluminium can be partially replaced by another metal.

2. The body (1) according to claim 1, **characterised in that** the body (1) comprises a base body (5), which is formed from a hard metal.

3. The body (1) according to claim 1 or 2, **characterised in that** a bonding layer (7) of titanium nitride is deposited directly on the base body (5), wherein the bonding layer (7) preferably has a thickness of less than 1.0 µm.

4. The body (1) according to any one of claims 1 to 3, **characterised in that** the first coating layer (3) is deposited on a further coating layer (6), which is formed from titanium carbonitride.

5. The body (1) according to claim 4, **characterised in that** the further coating layer (6) has a columnar structure in cross-section, which runs essentially normal to a surface of the coating layer (6).

6. The body (1) according to claim 4 or 5, **characterised in that** the further coating layer (6) has a thickness of up to 10 µm, preferably 1 to 8 µm, in particular 2 to 5 µm.

7. The body (1) according to any one of claims 4 to 6, **characterised in that** the further coating layer (6) is deposited on a bonding layer of titanium nitride.

8. The body (1) according to any one of claims 1 to 7, **characterised in that** the first coating layer (3) has a composition AlₓTi₁₋ₓN, wherein x ≥ 0.65, preferably ≥ 0.80, in particular ≥ 0.90.

9. The body (1) according to any one of claims 1 to 8, **characterised in that** the first coating layer (3) has a proportion of at least 50 %, preferably at least 60 %, in particular at least 75 % of a cubic phase, in particular a cubic AlₓTi₁₋ₓN phase.

10. The body (1) according to any one of claims 1 to 9, **characterised in that** the first coating layer (3) has a proportion of a hexagonal phase, in particular a hexagonal AlₓTi₁₋ₓN phase.

11. The body (1) according to any one of claims 1 to 10, **characterised in that** the first coating layer (3) has at least in sections a lamellar-like structure in cross-section in a region facing the body.

12. The body (1) according to any one of claims 1 to 11, **characterised in that** the first coating layer (3) has a thickness of up to 10 µm, preferably 3 to 8 µm.

13. The body (1) according to any one of claims 1 to 12, **characterised in that** a plurality of first coating layers (3) are arranged alternately with second coating layers (4).

14. The body (1) according to claim 13, **characterised in that** the alternately arranged first coating layers (3) and second coating layers (4) each have a thickness of less than 2 µm, preferably less than 1.2 µm, in particular less than 1.0 µm.

15. The body (1) according to claim 13 or 14, **characterised in that** the alternately arranged coating layers (3, 4) are arranged at the outside, wherein a second coating layer (4) is an outermost coating layer.

16. The body (1) according to any one of claims 1 to 15, **characterised in that** the body (1) is constituted as a cutting tool or a cutting insert.

17. A method for producing a body (1), in particular a body (1) according to any one of claims 1 to 16, wherein a coating (2) is deposited at least in sections using a CVD process, comprising a first coating layer (3) which is formed with aluminium, titanium and nitrogen, **characterised in that** at least one second coating layer (4) is deposited which is formed with aluminium, oxygen and nitrogen and optionally carbon, wherein aluminium is optionally replaced partially by another metal.

18. The method according to claim 17, **characterised in that** the coating (2) is deposited on a base body (5), which is formed from a hard metal.

19. The method according to claim 18, **characterised in that** a bonding layer of titanium nitride is deposited directly on the base body (5), wherein the bonding layer preferably has a thickness of less than 1.0 µm.

20. The method according to any one of claims 17 to 19, **characterised in that** a further coating layer (6) of a titanium carbonitride is deposited, on which the first coating layer (3) is deposited.

21. The method according to claim 20, **characterised in that** the further coating layer (6) is deposited at a temperature of 700 °C to 900 °C from a gaseous phase, which contains acetonitrile apart from titanium tetrachloride and a carrier gas.

22. The method according to any one of claims 17 to 21, **characterised in that** the first coating layer (3) is deposited from a gaseous phase with AlCl₃, HCl, H₂, TiCl₄ and a mixture of NH₃ and N₂.

23. The method according to claim 22, **characterised in that** the first coating layer (3) is deposited at a pressure of 15 to 80 mbar, preferably 20 to 40 mbar.

24. The method according to claim 22 or 23, **characterised in that** the first coating layer (3) is deposited at a temperature of 780 °C to 840 °C.

25. The method according to any one of claims 17 to 24, **characterised in that** the second coating layer (4) is deposited from a gaseous phase with AlCl₃, HCl, H₂, CO₂, CO and a mixture of NH₃ and N₂.

26. The method according to any one of claims 17 to 24, **characterised in that** a plurality of first coating layer (3) are deposited alternately with second coating layers (4).

27. The method according to claim 26, **characterised in that** the alternately deposited coating layers (3, 4) are deposited on the outside, wherein a second coating layer (4) is deposited as an outermost coating layer.

28. The method according to any one of claims 17 to 27, **characterised in that** all the coating layers are deposited by CVD.

## Revendications

1. Corps (1) qui présente au moins par endroits un revêtement (2) déposé par un procédé CVD, avec une première couche (3) de revêtement qui est formée d'aluminium, de titane et d'azote, **caractérisé en ce que** le revêtement (2) comporte au moins une deuxième couche (4) de revêtement qui est formée en aluminium, en oxygène et en azote, ainsi qu'en option en carbone, l'aluminium pouvant être partiellement remplacé par un autre métal.

2. Corps (1) selon la revendication 1, **caractérisé en ce que** le corps (1) comporte un corps de base (5) qui est formé en un métal dur.

3. Corps (1) selon la revendication 1 ou 2, **caractérisé en ce que** directement sur le corps de base (5) est déposée une couche de liaison (7) en nitrure de titane, la couche de liaison (7) présentant de préférence une épaisseur inférieure à 1,0 µm.

4. Corps (1) selon une quelconque des revendications 1 à 3, **caractérisé en ce que** la première couche (3) de revêtement est déposée sur une couche supplémentaire (6) de revêtement, qui est formée en un carbonitrure de titane.

5. Corps (1) selon la revendication 4, **caractérisé en ce que** dans la section transversale, la couche supplémentaire (6) de revêtement présente une structure columnaire qui s'étend sensiblement à la perpendiculaire d'une surface de la couche (6) de revêtement.

6. Corps (1) selon la revendication 4 ou 5, **caractérisé en ce que** la couche supplémentaire (6) de revêtement présente une épaisseur de jusqu'à 10 µm, de préférence de 1 à 8 µm, notamment de 2 à 5 µm.

7. Corps (1) selon l'une quelconque des revendications 4 à 6, **caractérisé en ce que** la couche supplémentaire (6) de revêtement est déposée sur une couche de liaison en nitrure de titane.

8. Corps (1) selon l'une quelconque des revendications 1 à 7, **caractérisé en ce que** la première couche (3) de revêtement comporte une composition d'AlₓTi₁₋ₓN, X étant ≥ 0,65, de préférence ≥ 0, 0, notamment ≥ 0,90.

9. Corps (1) selon l'une quelconque des revendications 1 à 8, **caractérisé en ce que** la première couche (3) de revêtement comporte une part d'au moins 50 %, de préférence d'au moins 60 %, notamment d'au moins 75 % d'une phase cubique, notamment d'une phase cubique d'AlₓTi₁₋ₓN.

10. Corps (1) selon l'une quelconque des revendications 1 à 9, **caractérisé en ce que** la première couche (3) de revêtement comporte une part d'une phase hexagonale, notamment d'une phase hexagonale d'AlₓTi₁₋ₓN.

11. Corps (1) selon l'une quelconque des revendications 1 à 10, **caractérisé en ce que** dans une zone faisant face au corps, dans la section transversale, la première couche (3) de revêtement comporte au moins par endroits une structure lamellée.

12. Corps (1) selon l'une quelconque des revendications 1 à 11, **caractérisé en ce que** la première couche (3) de revêtement présente une épaisseur de jusqu'à 10 µm, de préférence de 3 à 8 µm.

13. Corps (1) selon l'une quelconque des revendications 1 à 12, **caractérisé en ce que** plusieurs premières couches (3) de revêtement sont placées en alternance avec des deuxièmes couches (4) de revêtement.

14. Corps (1) selon la revendication 13, **caractérisé en ce que** les premières couches (3) de revêtement et les deuxièmes couches (4) de revêtement placées en alternance présentent chacune une épaisseur inférieure à 2 µm, d préférence inférieure à 1,2 µm, notamment inférieure à 1,0 µm.

15. Corps (1) selon la revendication 13 ou 14, **caractérisé en ce que** les couches (3, 4) de revêtement placées en alternance sont placées sur la face extérieure, une deuxième couche (4) de revêtement étant une couche de revêtement la plus à l'extérieur.

16. Corps (1) selon l'une quelconque des revendications 1 à 15, **caractérisé en ce que** le corps (1) est conçu en tant qu'outil de coupe ou insert de coupe.

17. Procédé destiné à fabriquer un corps (1), notamment un corps (1) selon l'une quelconque des revendications 1 à 16, lors duquel, au moins par endroits, on dépose par un procédé CVD un revêtement (2) avec une première couche (3) de revêtement, que l'on forme avec de l'aluminium, du titane et de l'azote, **caractérisé en ce qu'**on dépose au moins une deuxième couche (4) de revêtement, que l'on forme avec de l'aluminium, de l'oxygène et de l'azote, ainsi qu'en option avec du carbone, sachant qu'en option, on remplace partiellement l'aluminium par un autre métal.

18. Procédé selon la revendication 17, **caractérisé en ce qu'**on dépose le revêtement (2) sur un corps de base (5) qui est formé en un métal dur.

19. Procédé selon la revendication 18, **caractérisé en ce qu'**on dépose directement sur le corps de base (5) une couche de liaison en nitrure de titane, la couche de liaison présentant de préférence une épaisseur inférieure à 1,0 µm.

20. Procédé selon l'une quelconque des revendications 17 à 9, **caractérisé en ce qu'**aune dépose une couche supplémentaire (6) en un carbonitrure de titane, sur laquelle on dépose la première couche (3) de revêtement.

21. Procédé selon la revendication 20, **caractérisé en ce qu'**on dépose la couche supplémentaire (6) de revêtement à une température de 700 °C à 900 °C en une phase gazeuse, qui hormis du tétrachlorure de titane et un gaz porteur, contient de l'acétonitrile.

22. Procédé selon l'une quelconque des revendications 17 à 21, **caractérisé en ce qu'**one dépose la première couche (3) de revêtement en une phase gazeuse avec de l'AlCl₃, du HCI, du H₂, du TiCl₄ et un mélange de NH₃ et de N₂.

23. Procédé selon la revendication 22, **caractérisé en ce qu'**on dépose la première couche (3) de revêtement à une pression de 15 à 80 mbar, de préférence de 20 à 40 mbar.

24. Procédé selon la revendication 22 ou 23, **caractérisé en ce qu'**on dépose la première couche (3) de revêtement à une température de 780 °C à 840 °C.

25. Procédé selon l'une quelconque des revendications 17 à 24, **caractérisé en ce qu'**on dépose la deuxième couche (4) en une phase gazeuse avec de l'AlCl₃, du HCI, du H₂, du CO₂, du CO et un mélange de NH₃ et de N₂.

26. Procédé selon l'une quelconque des revendications 17 à 24, **caractérisé en ce qu'**on dépose plusieurs premières couches (3) de revêtement, en alternance avec des deuxièmes couches (4) de revêtement.

27. Procédé selon la revendication 26, **caractérisé en ce qu'**on dépose les couches (3, 4) de revêtement déposées en alternance sur la face extérieure, sachant qu'on dépose une deuxième couche (4) de revêtement en tant qu'une couche de revêtement la plus à l'extérieur.

28. Procédé selon l'une quelconque des revendications 17 à 27, **caractérisé en ce qu'**on dépose toutes les couches de revêtement par CVD.
